(19) Europäisches Patentamt / European Patent Office / Office européen des brevets

(11) **EP 4 246 231 A1**

(12) **EUROPEAN PATENT APPLICATION**


(43) Date of publication:
**20.09.2023 Bulletin 2023/38**

(21) Application number: **22163109.6**

(22) Date of filing: **18.03.2022**

(51) International Patent Classification (IPC):
***G03F 7/20*** *(2006.01)* ***G01N 21/21*** *(2006.01)*
***G03H 1/04*** *(2006.01)*

(52) Cooperative Patent Classification (CPC):
**G03F 7/70633; G03F 7/70616; G03F 7/70641; G03H 1/0443**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**



(71) Applicants:
- **Stichting VU**
  **1081 HV Amsterdam (NL)**
- **Stichting Nederlandse Wetenschappelijk Onderzoek Instituten**
  **3526 KV Utrecht (NL)**
- **Universiteit van Amsterdam**
  **1012 WX Amsterdam (NL)**
- **ASML Netherlands B.V.**
  **5500 AH Veldhoven (NL)**

(72) Inventors:
- **DEN BOEF, Arie, Jeffrey**
  **5500 AH Veldhoven (NL)**
- **VAN SCHAIJK, Theodorus, Thomas, Marinus**
  **5500 AH Veldhoven (NL)**
- **BUIJS, Robin, Daniel**
  **5500 AH Veldhoven (NL)**
- **DE BOER, Johannes, Fitzgerald**
  **1081 HV Amsterdam (NL)**
- **MESSINIS, Christos**
  **1081 HV Amsterdam (NL)**

(74) Representative: **ASML Netherlands B.V.**
**Corporate Intellectual Property**
**P.O. Box 324**
**5500 AH Veldhoven (NL)**


(54) **A METHOD FOR DETERMINING A VERTICAL POSITION OF A STRUCTURE ON A SUBSTRATE AND ASSOCIATED APPARATUSES**


(57) A method for determining a vertical position of a structure on a substrate with respect to a nominal vertical position is disclosed. The method comprises obtaining complex field data relating to scattered radiation from said structure, for a plurality of different wavelengths, determining variation in a phase parameter with wavelength from said complex field data; and determining said vertical position with respect to a nominal vertical position from the determined variation in phase with wavelength.

ILL
θ
S
T
ILL
T
(a)

ILL
θ
ΔZ
S
T
ILL
ΔX
T
(b)


Fig. 10

EP 4 246 231 A1

## Description

### FIELD

The present invention relates to a metrology method and device which may, for example, be used for determining a characteristic of structures on a substrate.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern (also often referred to as "design layout" or "design") at a patterning device (e.g., a mask) onto a layer of radiation-sensitive material (resist) provided on a substrate (e.g., a wafer).

To project a pattern on a substrate a lithographic apparatus may use electromagnetic radiation. The wavelength of this radiation determines the minimum size of features which can be formed on the substrate. Typical wavelengths currently in use are 365 nm (i-line), 248 nm, 193 nm and 13.5 nm. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

Low-ki lithography may be used to process features with dimensions smaller than the classical resolution limit of a lithographic apparatus. In such process, the resolution formula may be expressed as $CD = k_1 \times \lambda / NA$, where $\lambda$ is the wavelength of radiation employed, NA is the numerical aperture of the projection optics in the lithographic apparatus, CD is the "critical dimension" (generally the smallest feature size printed, but in this case half-pitch) and $k_1$ is an empirical resolution factor. In general, the smaller $k_1$ the more difficult it becomes to reproduce the pattern on the substrate that resembles the shape and dimensions planned by a circuit designer in order to achieve particular electrical functionality and performance. To overcome these difficulties, sophisticated fine-tuning steps may be applied to the lithographic projection apparatus and/or design layout. These include, for example, but not limited to, optimization of NA, customized illumination schemes, use of phase shifting patterning devices, various optimization of the design layout such as optical proximity correction (OPC, sometimes also referred to as "optical and process correction") in the design layout, or other methods generally defined as "resolution enhancement techniques" (RET). Alternatively, tight control loops for controlling a stability of the lithographic apparatus may be used to improve reproduction of the pattern at low k1.

During the manufacturing process there is a need to inspect the manufactured structures and/or to measure characteristics of the manufactured structures. Suitable inspection and metrology apparatuses are known in the art. One of the known metrology apparatuses is a scatterometer and, for example, a dark field scatterometer.

Patent application publication US2016/0161864A1, patent application publication US2010/0328655A1 and patent application publication US2006/0066855A1 discuss embodiments of a photolithographic apparatus and, in particular, embodiments of a dark field scatterometer. WO2021/121733A1 discusses embodiments of a dark field holographic microscope (DHM). A DHM will allow the use of a simple objective lens, which allows a significant size and weight reduction of the sensor optics compared to a dark field scatterometer. This makes it easier to move the sensor over the wafer, while simultaneously enabling the use of multiple sensors on a single wafer. The cited documents are herein incorporated by reference.

In some of these metrology devices, a non-normal (oblique) illumination incidence may be used to illuminate a target on a substrate during a measurement. Because of this, and the fact that an illumination spot will typically not be completely inhomogeneous, it is desirable that the vertical position of the target with respect to the measurement spot is maintained consistent and therefore known accurately.

### SUMMARY

In a first aspect of the invention, there is provided a method for determining a vertical position of a structure on a substrate with respect to a nominal vertical position; comprising: obtaining complex field data relating to scattered radiation from said structure, for a plurality of different wavelengths; determining variation in a phase parameter with wavelength from said complex field data; and determining said vertical position with respect to a nominal vertical position from the determined variation in phase with wavelength.

In a other aspects of the invention, there is provided a computer program, processing arrangement and holographic metrology apparatus configured to carry out the method of the first aspect.

## BRIEF DESCRIPTION OF THE DRAWINGS

Embodiments of the invention will now be described, by way of example only, with reference to the accompanying schematic drawings, in which:

- Figure 1 depicts a schematic overview of a lithographic apparatus;
- Figure 2 depicts a schematic overview of a lithographic cell;
- Figure 3 depicts a schematic representation of holistic lithography, representing a cooperation between three key technologies to optimize semiconductor manufacturing;
- Figure 4 depicts a schematic overview of a scatterometry apparatus used as a metrology device, which may comprise a dark field digital holographic microscope according to embodiments of the invention;
- Figure 5 depicts schematically an example of a diffraction-based dark field metrology device operated in a parallel acquisition scheme;
- Figure 6 depicts schematically a different example of a diffraction-based dark field metrology device operated in a sequential acquisition scheme;
- Figure 7 depicts schematically an example of a dark field digital holographic microscope operated in a sequential acquisition scheme;
- Figure 8 depicts schematically a dark field digital holographic microscope (df-DHM) operated in a parallel acquisition scheme, in accordance with an embodiment;
- Figures 9(a), 9(b), 9(c), 9(d) comprise (a) a schematic diagram of a dark field scatterometer for use in measuring targets according to embodiments of the invention using a first pair of illumination apertures, and (b) a detail of diffraction spectrum of a target grating for a given direction of illumination;
- Figures 10(a), 10(b) depict schematically the effect of oblique illumination on a target at (a) a first vertical target position and (b) a second vertical target position;
- Figure 11 is a schematic illustration of the relationship between optical path difference and vertical position offset; and
- Figure 12 depicts a block diagram of a computer system for controlling a digital holographic microscope.

## DETAILED DESCRIPTION

In the present document, the terms "radiation" and "beam" are used to encompass all types of electromagnetic radiation, including ultraviolet radiation (e.g. with a wavelength of 365, 248, 193, 157 or 126 nm) and EUV (extreme ultra-violet radiation, e.g. having a wavelength in the range of about 5-100 nm).

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate. The term "light valve" can also be used in this context. Besides the classic mask (transmissive or reflective, binary, phase-shifting, hybrid, etc.), examples of other such patterning devices include a programmable mirror array and a programmable LCD array.

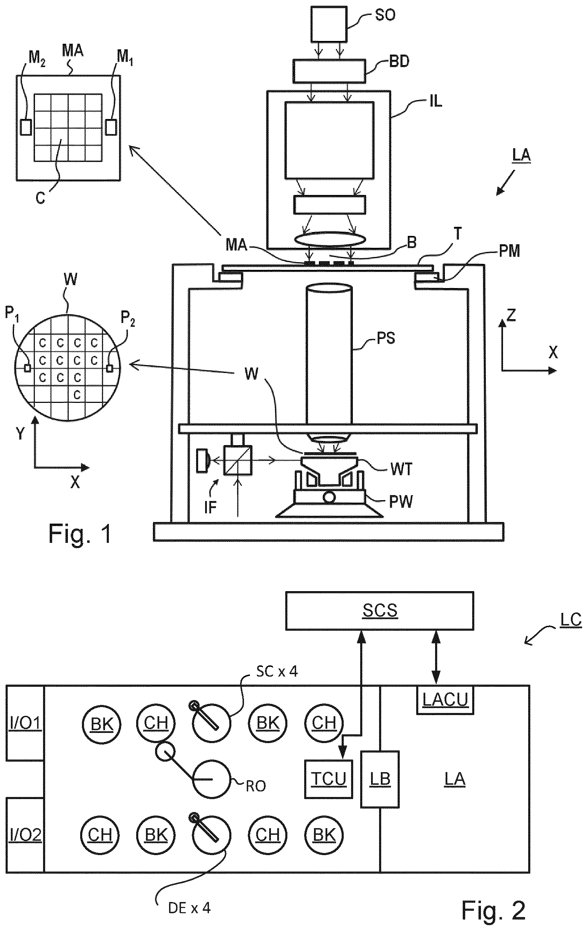

Figure 1 schematically depicts a lithographic apparatus LA. The lithographic apparatus LA includes an illumination system (also referred to as illuminator) IL configured to condition a radiation beam B (e.g., UV radiation, DUV radiation or EUV radiation), a mask support (e.g., a mask table) MT constructed to support a patterning device (e.g., a mask) MA and connected to a first positioner PM configured to accurately position the patterning device MA in accordance with certain parameters, a substrate support (e.g., a wafer table) WT constructed to hold a substrate (e.g., a resist coated wafer) W and connected to a second positioner PW configured to accurately position the substrate support in accordance with certain parameters, and a projection system (e.g., a refractive projection lens system) PS configured to project a pattern imparted to the radiation beam B by patterning device MA onto a target portion C (e.g., comprising one or more dies) of the substrate W.

In operation, the illumination system IL receives a radiation beam from a radiation source SO, e.g. via a beam delivery system BD. The illumination system IL may include various types of optical components, such as refractive, reflective, magnetic, electromagnetic, electrostatic, and/or other types of optical components, or any combination thereof, for directing, shaping, and/or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PS.

The lithographic apparatus LA may be of a type wherein at least a portion of the substrate may be covered by a liquid having a relatively high refractive index, e.g., water, so as to fill a space between the projection system PS and the substrate W - which is also referred to as immersion lithography. More information on immersion techniques is given in US6952253, which is incorporated herein by reference.

The lithographic apparatus LA may also be of a type having two or more substrate supports WT (also named "dual stage"). In such "multiple stage" machine, the substrate supports WT may be used in parallel, and/or steps in preparation of a subsequent exposure of the substrate W may be carried out on the substrate W located on one of the substrate support WT while another substrate W on the other substrate support WT is being used for exposing a pattern on the other substrate W.

In addition to the substrate support WT, the lithographic apparatus LA may comprise a measurement stage. The measurement stage is arranged to hold a sensor and/or a cleaning device. The sensor may be arranged to measure a property of the projection system PS or a property of the radiation beam B. The measurement stage may hold multiple sensors. The cleaning device may be arranged to clean part of the lithographic apparatus, for example a part of the projection system PS or a part of a system that provides the immersion liquid. The measurement stage may move beneath the projection system PS when the substrate support WT is away from the projection system PS.

In operation, the radiation beam B is incident on the patterning device, e.g. mask, MA which is held on the mask support MT, and is patterned by the pattern (design layout) present on patterning device MA. Having traversed the mask MA, the radiation beam B passes through the projection system PS, which focuses the beam onto a target portion C of the substrate W. With the aid of the second positioner PW and a position measurement system IF, the substrate support WT can be moved accurately, e.g., so as to position different target portions C in the path of the radiation beam B at a focused and aligned position. Similarly, the first positioner PM and possibly another position sensor (which is not explicitly depicted in Figure 1) may be used to accurately position the patterning device MA with respect to the path of the radiation beam B. Patterning device MA and substrate W may be aligned using mask alignment marks M1, M2 and substrate alignment marks PI, P2. Although the substrate alignment marks PI, P2 as illustrated occupy dedicated target portions, they may be located in spaces between target portions. Substrate alignment marks P1, P2 are known as scribe-lane alignment marks when these are located between the target portions C.

As shown in Figure 2 the lithographic apparatus LA may form part of a lithographic cell LC, also sometimes referred to as a lithocell or (litho)cluster, which often also includes apparatus to perform pre- and post-exposure processes on a substrate W. Conventionally these include spin coaters SC to deposit resist layers, developers DE to develop exposed resist, chill plates CH and bake plates BK, e.g. for conditioning the temperature of substrates W e.g. for conditioning solvents in the resist layers. A substrate handler, or robot, RO picks up substrates W from input/output ports I/O1, I/O2, moves them between the different process apparatus and delivers the substrates W to the loading bay LB of the lithographic apparatus LA. The devices in the lithocell, which are often also collectively referred to as the track, are typically under the control of a track control unit TCU that in itself may be controlled by a supervisory control system SCS, which may also control the lithographic apparatus LA, e.g. via lithography control unit LACU.

In order for the substrates W exposed by the lithographic apparatus LA to be exposed correctly and consistently, it is desirable to inspect substrates to measure properties of patterned structures, such as overlay errors between subsequent layers, line thicknesses, critical dimensions (CD), etc. For this purpose, inspection tools (not shown) may be included in the lithocell LC. If errors are detected, adjustments, for example, may be made to exposures of subsequent substrates or to other processing steps that are to be performed on the substrates W, especially if the inspection is done before other substrates W of the same batch or lot are still to be exposed or processed.

An inspection apparatus, which may also be referred to as a metrology apparatus, is used to determine properties of the substrates W, and in particular, how properties of different substrates W vary or how properties associated with different layers of the same substrate W vary from layer to layer. The inspection apparatus may alternatively be constructed to identify defects on the substrate W and may, for example, be part of the lithocell LC, or may be integrated into the lithographic apparatus LA, or may even be a stand-alone device. The inspection apparatus may measure the properties on a latent image (image in a resist layer after the exposure), or on a semi-latent image (image in a resist layer after a post-exposure bake step PEB), or on a developed resist image (in which the exposed or unexposed parts of the resist have been removed), or even on an etched image (after a pattern transfer step such as etching).

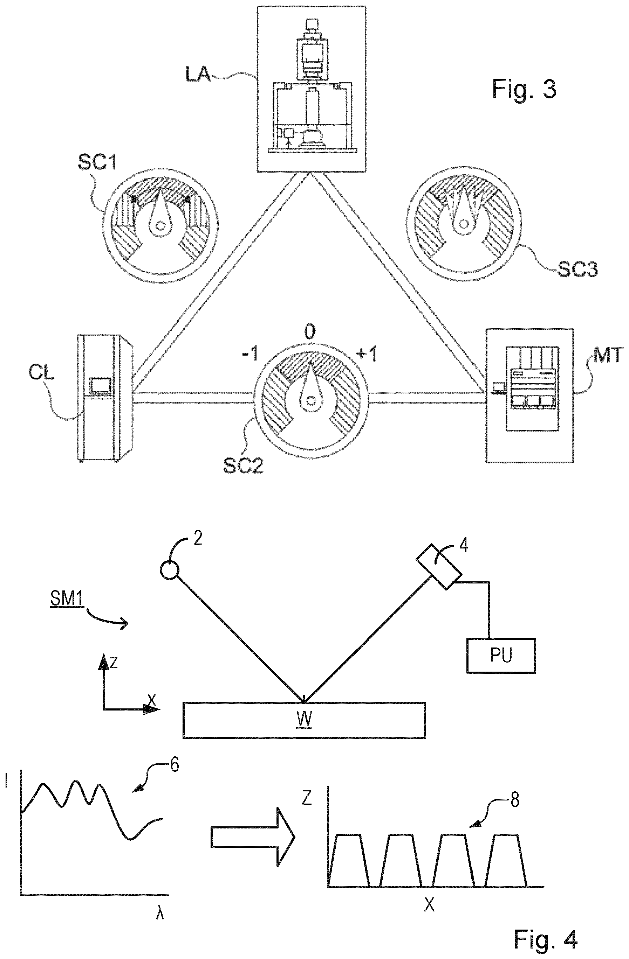

Typically the patterning process in a lithographic apparatus LA is one of the most critical steps in the processing which requires high accuracy of dimensioning and placement of structures on the substrate W. To ensure this high accuracy, three systems may be combined in a so called "holistic" control environment as schematically depicted in Fig. 3. One of these systems is the lithographic apparatus LA which is (virtually) connected to a metrology tool MT (a second system) and to a computer system CL (a third system). The key of such "holistic" environment is to optimize the cooperation between these three systems to enhance the overall process window and provide tight control loops to ensure that the patterning performed by the lithographic apparatus LA stays within a process window. The process window defines a range of process parameters (e.g. dose, focus, overlay) within which a specific manufacturing process yields a defined result (e.g. a functional semiconductor device) - typically within which the process parameters in the lithographic process or patterning process are allowed to vary.

The computer system CL may use (part of) the design layout to be patterned to predict which resolution enhancement techniques to use and to perform computational lithography simulations and calculations to determine which mask layout and lithographic apparatus settings achieve the largest overall process window of the patterning process (depicted in Fig. 3 by the double arrow in the first scale SC1). Typically, the resolution enhancement techniques are arranged to match the patterning possibilities of the lithographic apparatus LA. The computer system CL may also be used to detect where within the process window the lithographic apparatus LA is currently operating (e.g. using input from the metrology tool MT) to predict whether defects may be present due to e.g. sub-optimal processing (depicted in Fig. 3 by the arrow pointing "0" in the second scale SC2).

The metrology tool MT may provide input to the computer system CL to enable accurate simulations and predictions, and may provide feedback to the lithographic apparatus LA to identify possible drifts, e.g. in a calibration status of the lithographic apparatus LA (depicted in Fig. 3 by the multiple arrows in the third scale SC3).

In lithographic processes, it is desirable to make frequently measurements of the structures created, e.g., for process control and verification. Tools to make such measurement are typically called metrology tools MT. Different types of metrology tools MT for making such measurements are known, including scanning electron microscopes or various forms of scatterometer metrology tools MT. Scatterometers are versatile instruments which allow measurements of the parameters of a lithographic process by having a sensor in the pupil or a conjugate plane with the pupil of the objective of the scatterometer, measurements usually referred as pupil based measurements, or by having the sensor in the image plane or a plane conjugate with the image plane, in which case the measurements are usually referred as image or field based measurements. Such scatterometers and the associated measurement techniques are further described in patent applications US20100328655, US2011102753A1, US20120044470A, US20110249244, US20110026032 or EP1,628,164A, incorporated herein by reference in their entirety. Aforementioned scatterometers may measure gratings using light from soft x-ray and visible to near-IR wavelength range.

In a first embodiment, the scatterometer MT is an angular resolved scatterometer. In such a scatterometer reconstruction methods may be applied to the measured signal to reconstruct or calculate properties of the grating. Such reconstruction may, for example, result from simulating interaction of scattered radiation with a mathematical model of the target structure and comparing the simulation results with those of a measurement. Parameters of the mathematical model are adjusted until the simulated interaction produces a diffraction pattern similar to that observed from the real target.

In a second embodiment, the scatterometer MT is a spectroscopic scatterometer MT. In such spectroscopic scatterometer MT, the radiation emitted by a radiation source is directed onto the target and the reflected or scattered radiation from the target is directed to a spectrometer detector, which measures a spectrum (i.e. a measurement of intensity as a function of wavelength) of the specular reflected radiation. From this data, the structure or profile of the target giving rise to the detected spectrum may be reconstructed, e.g. by Rigorous Coupled Wave Analysis and non-linear regression or by comparison with a library of simulated spectra.

In a third embodiment, the scatterometer MT is a ellipsometric scatterometer. The ellipsometric scatterometer allows for determining parameters of a lithographic process by measuring scattered radiation for each polarization states. Such metrology apparatus emits polarized light (such as linear, circular, or elliptic) by using, for example, appropriate polarization filters in the illumination section of the metrology apparatus. A source suitable for the metrology apparatus may provide polarized radiation as well. Various embodiments of existing ellipsometric scatterometers are described in US patent applications 11/451,599, 11/708,678, 12/256,780, 12/486,449, 12/920,968, 12/922,587, 13/000,229, 13/033,135, 13/533,110 and 13/891,410 incorporated herein by reference in their entirety.

A metrology apparatus, such as a scatterometer, is depicted in Figure 4. It comprises a broadband (white light) radiation projector 2 which projects radiation onto a substrate W (optionally having been spectrally filtered to be narrowband prior to the substrate W). The reflected or scattered radiation is passed to a spectrometer detector 4, which measures a spectrum 6 (i.e. a measurement of intensity as a function of wavelength) of the specular reflected radiation. From this data, the structure or profile 8 giving rise to the detected spectrum may be reconstructed by processing unit PU, e.g. by Rigorous Coupled Wave Analysis and non-linear regression or by comparison with a library of simulated spectra as shown at the bottom of Figure 3. In general, for the reconstruction, the general form of the structure is known and some parameters are assumed from knowledge of the process by which the structure was made, leaving only a few parameters of the structure to be determined from the scatterometry data. Such a scatterometer may be configured as a normal-incidence scatterometer or an oblique-incidence scatterometer.

Overall measurement quality of a lithographic parameter via measurement of a metrology target is at least partially determined by the measurement recipe used to measure this lithographic parameter. The term "substrate measurement recipe" may include one or more parameters of the measurement itself, one or more parameters of the one or more patterns measured, or both. For example, if the measurement used in a substrate measurement recipe is a diffraction-based optical measurement, one or more of the parameters of the measurement may include the wavelength of the radiation, the polarization of the radiation, the incident angle of radiation relative to the substrate, the orientation of radiation relative to a pattern on the substrate, etc. One of the criteria to select a measurement recipe may, for example, be a sensitivity of one of the measurement parameters to processing variations. More examples are described in US patent application US2016-0161863 and published US patent application US 2016/0370717A1incorporated herein by reference in its entirety.

Another type of metrology tool used in IC manufacture is a topography measurement system, level sensor or height sensor. Such a tool may be integrated in the lithographic apparatus, for measuring a topography of a top surface of a substrate (or wafer). A map of the topography of the substrate, also referred to as height map, may be generated from these measurements indicating a height of the substrate as a function of the position on the substrate. This height map may subsequently be used to correct the position of the substrate during transfer of the pattern on the substrate, in order to provide an aerial image of the patterning device in a properly focus position on the substrate. It will be understood that "height" in this context refers to a dimension broadly out of the plane to the substrate (also referred to as Z-axis). Typically, the level or height sensor performs measurements at a fixed location (relative to its own optical system) and a relative movement between the substrate and the optical system of the level or height sensor results in height measurements at locations across the substrate.

In order to monitor the lithographic process, parameters of the patterned substrate are measured. Parameters may include, for example, the overlay error between successive layers formed in or on the patterned substrate. This measurement may be performed on a product substrate and/or on a dedicated metrology target. There are various techniques for making measurements of the microscopic structures formed in lithographic processes, including the use of scanning electron microscopes and various specialized tools. A fast and non-invasive form of specialized inspection tool is a scatterometer in which a beam of radiation is directed onto a target on the surface of the substrate and properties of the scattered or reflected beam are measured.

Examples of known scatterometers include angle-resolved scatterometers of the type described in US2006033921A1 and US2010201963A1. The targets used by such scatterometers are relatively large, e.g., 40μm by 40μm, gratings and the measurement beam generates a spot that is smaller than the grating (i.e., the grating is underfilled). In addition to measurement of feature shapes by reconstruction, diffraction based overlay can be measured using such apparatus, as described in published patent application US2006066855A1. Diffraction-based overlay metrology using dark field imaging of the diffraction orders enables overlay measurements on smaller targets. Examples of dark field imaging metrology can be found in international patent applications WO 2009/078708 and WO 2009/106279 which documents are hereby incorporated by reference in their entirety. Further developments of the technique have been described in published patent publications US20110027704A, US20110043791A, US2011102753A1, US20120044470A, US20120123581A, US20130258310A, US20130271740A and WO2013178422A1. These targets can be smaller than the illumination spot and may be surrounded by product structures on a wafer. Multiple gratings can be measured in one image, using a composite grating target. The contents of all these applications are also incorporated herein by reference.

Dark field microscopes, such as the metrology device mentioned above and more generally, have the problem of having a limited range of angles for illumination of the target and/or detection of the light that is diffracted by the target, as it may be required that the total range of angles (corresponding to regions within the angle resolved pupil) are shared between the illumination path and detection path. This limits the effective NA in illumination and detection.

In a diffraction-based dark field metrology device, a beam of radiation is directed onto a metrology target and one or more properties of the scattered radiation are measured so as to determine a property of interest of the target. The properties of the scattered radiation may comprise, for example, intensity at a single scattering angle (e.g., as a function of wavelength) or intensity at one or more wavelengths as a function of scattering angle.

Measurement of targets in dark field metrology may comprise, for example, measuring the a first intensity of the 1$^{st}$ diffraction order $I_{+1}$ and a second intensity of the -1$^{st}$ diffraction order ($I_{-1}$) and calculating an intensity asymmetry ($A = I_{+1} - I_{-1}$), which is indicative of asymmetry in the target. The metrology targets may comprise one or more grating structures from which a parameter of interest may be inferred from such intensity asymmetry measurements, e.g., the targets are designed such that the asymmetry in the target varies with the parameter of interest. For example, in overlay metrology a target may comprise at least one composite grating formed by at least a pair of overlapping sub-gratings that are patterned in different layers of the semiconductor device. Asymmetry of the target will therefore be dependent on alignment of the two layers and therefore overlay. Other targets may be formed with structures which are exposed with different degrees of variation based on the focus setting used during the exposure; the measurement of which enabling that focus setting to be inferred back (again through intensity asymmetry).

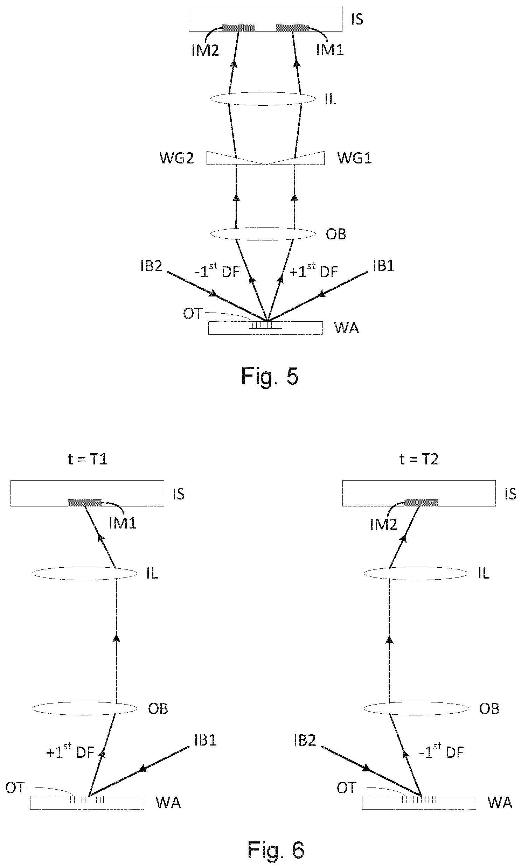

Figure 5 and Figure 6 schematically illustrate two examples of diffraction-based dark field metrology devices. Note that for the sake of simplicity, both figures only show some of the components that are sufficient for the purpose of describing working principle of the two devices.

As illustrated in Figure 5, a first illumination beam of radiation IB1 may be obliquely incident onto an overlay target of a substrate WA from one side of the device. The grating based overlay target may diffract the first illumination beam into a number of diffraction orders. Since the device is configured for dark field imaging, the zeroth diffraction order may be either blocked by an optical component or configure to fall completely outside the numerical aperture of the objective lens OB. At least one non-zeroth diffraction order, e.g., positive first diffraction order +1$^{st}$ DF, may be collected by the objective lens OB. At the pupil plane of the objective lens OB, a first wedge WG1 may be used to redirect the diffracted radiation to follow a desired beam path. Finally, an imaging lens may be used to focus the diffraction order, e.g., positive first diffraction order +1$^{st}$ DF, onto an image sensor IS such that a first image IM1 is formed at a first location.

Similarly, a second illumination beam of radiation IB2 may be obliquely incident onto the same overlay target OT of the substrate WA from the opposite side of the system. The incident angle of the second illumination beam IB2 may be same as that of the first illumination beam IB1. At least one non-zeroth diffraction order, e.g., negative first diffraction order -1$^{st}$ DF, may be collected by the objective lens OB and subsequently redirected by a second wedge WG2. The negative first diffraction order -1$^{st}$ DF may then be focused by the imaging lens IL onto the image sensor IS such that a second image IM2 is formed at a second location.

The example of Figure 5 is operated in a parallel acquisition scheme. The overlay target is illuminated simultaneously by both illumination beams IB1, IB2. Correspondingly, the two spatially separated images IM1, IM2 of the overlay target are acquired at the same time. Such a parallel acquisition scheme allows for a fast measurement speed and hence high throughput. However, the pupil plane of the objective lens OB has to be shared by the two diffraction orders, e.g., +1$^{st}$ DF and -1$^{st}$ DF. A consequence of dividing the pupil into mutually exclusive illumination and detection pupils is that there is a consequent reduction in the illumination NA and in the detection NA. While there is some flexibility in trade-off between the illumination NA and detection NA, ultimately having both the illumination NA the detection NA as large as is often desirable is not possible within a single pupil. This results in a limited range of angles for each corresponding illumination beam and for the +1$^{st}$ DF and -1$^{st}$ DF beams, which in turn limits the range of allowable grating pitch sizes and/or illumination wavelengths and hence imposes a tight requirement for designing such a metrology system.

Figure 6 schematically illustrates another exemplary dark field metrology device (or different operation mode of the device of Figure 5). The main difference is that the metrology device of Figure 6 is operated in a sequential acquisition scheme. In the sequential acquisition scheme, a metrology target OT is only illuminated by one illumination beam from one direction at any time instance and thereby only one image of the target is formed and acquired at any point in time. Referring to Figure 6, at a first time instance t=T1, a first illumination beam IB1 may be switched on and directed obliquely onto an overlay target OT of a substrate WA from one side of the metrology device. After interaction with the gratings of the overlay target, a number of diffraction orders may be generated. At least one of the non-zeroth diffraction order, e.g., positive first diffraction order +1$^{st}$ DF, may be collected by an objective lens OB and subsequently focused by an imaging lens IL onto an image sensor IS.

Subsequent to the first image IM1 of the overlay gratings being acquired, at a second time instance t=T2, the first illumination beam IB1 is switched off and a second illumination beam IB2 is switched on. The second illumination beam IB2 may be directly obliquely onto the same overlay target from an opposite side of the metrology device. At least one of the generated diffraction orders, e.g., negative first diffraction order -1$^{st}$ DF, may be collected by the objective lens OB and subsequently focused onto the image sensor IS to form a second image IM2 of the overlay target. Note that both images IM1 and IM2 may be formed at a common position on the image sensor.

With this time multiplexed acquisition scheme, the full NA of the objective lens OB is made available for detecting the diffracted beams +1$^{st}$ DF and -1$^{st}$ DF. No limitation in objective NA means a wider range of relevant design parameters, such as grating pitch sizes, illumination wavelengths and illumination angles, is allowed and a greater flexibility in system design can be obtained. However, the fact that multiple image acquisitions are needed means measurement speed is reduced and hence system throughput is impacted.

In addition, accurate determination of e.g., overlay error, relies on accurate measurement of a minute relative intensity difference (or intensity asymmetry) between the two acquired images IM1, IM2. The typical relative intensity difference is on the order of $10^{-4}$ of the intensity of one of the acquired images, e.g., IM1 or IM2. Such a small intensity difference could easily be dwarfed by any intensity and/or wavelength fluctuations of illumination radiation. Therefore, the illumination beams are required to stay stable during consecutive image acquisitions. This can be achieved by using a stable light source providing desired intensity and wavelength stabilities. Alternatively, additional hardware and software, such as for example intensity/wavelength monitoring device and corresponding feedback control loop, should be incorporated into the metrology device such that intensity and/or wavelength fluctuations of the illumination beams are actively monitored and well compensated. In some cases, an intensity monitoring device may be used to actively track the intensity of the illumination beams. The signal generated from the intensity monitoring device may be used to (e.g., electronically) correct the intensity fluctuations of the illumination beams. All these solutions add complexity and cost to the overall system.

Some or all of aforementioned problems could be addressed by using digital holographic microscopy, in particular dark field digital holographic microscopy. Digital holographic microscopy is an imaging technology that combines holography with microscopy. Different from other microscopy methods that record projected images of an object, digital holographic microscopy records holograms formed by interference between object radiation obtained by irradiation of a three-dimensional (3D) object with object radiation and reference radiation that is coherent with the object radiation.

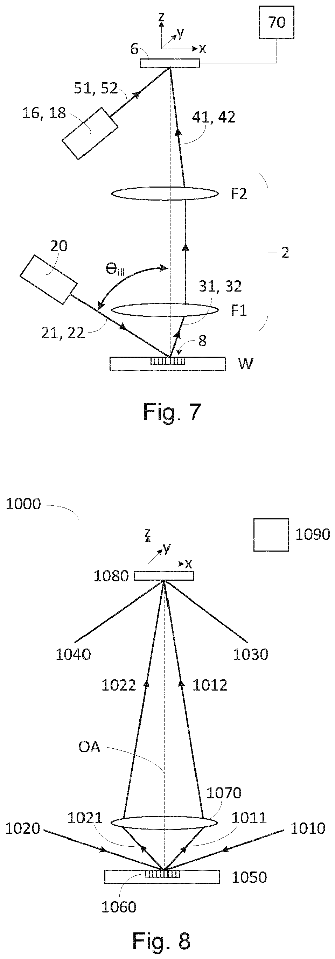

Images may be captured using, for example a charge coupled device (CCD) or a complementary metal oxide semiconductor (CMOS). Since the object radiation is radiation scattered from the object, wave-front of the object radiation is therefore modulated or shaped by the object. Said scattered radiation may comprise reflected radiation, diffracted radiation, or transmitted radiation. Therefore, the wavefront of the object radiation carries information of the irradiated object, e.g., 3D shape information. Based on the captured images of holograms, images of the object can be numerically reconstructed by using a computer reconstruction algorithm. An important advantage of hologram based metrology over intensity based metrology, as described in examples of Figures 7 and 8, is that hologram based metrology allows both intensity and phase information of an object to be obtained. With additional phase information, characteristics of the object can be determined with better accuracy.

The international patent application WO2019197117A1, incorporated herein by reference, discloses a method and metrology apparatus based on a dark field digital holographic microscope (df-DHM) to determine a characteristic, e.g., overlay, of a structure manufactured on a substrate. For the purpose of description, Figure 3 of the international patent application WO2019197117A1 is replicated in Figure 7. Figure 7 schematically illustrates the disclosed df-DHM specifically adapted for use in lithographic process metrology.

In comparison to the former examples shown in Figures 7 and 8, the df-DHM in Figure 7 further comprises a reference optical unit 16, 18 which is used to provide additional two reference radiation beams 51, 52 (the reference radiation). Such two reference radiation beams 51, 52 are respectively paired with two corresponding portions 41, 42 of the scattered radiation beams 31, 32 (the object radiation). The two scattered-reference beam pairs are used sequentially to form two interference patterns. Coherence control is provided by way of adjusting the relative optical path-length difference (OPD) between the two scattered-reference beams within each beam pair. However, no coherence control is available between the two beam pairs.

Due to the use of a single light source and insufficient coherence control, all four radiation beams, i.e. the first portion 41 of the scattered radiation 31, the first reference radiation 51, the second portion 42 of the scattered radiation 32 and the second reference radiation 52, are mutually coherent. If these four mutually coherent radiation beams were allowed to reach the same position of the sensor 6 at the same time, namely operating in a parallel acquisition scheme, multiple interference patterns comprising desired information containing patterns and undesired artefact-contributing patterns would overlap each other. The undesired interference patterns may be formed by interference between e.g., the portion 41 of the first scattered radiation 31 and the portion 42 of the second scattered radiation 32. Since it would be technically challenging and time consuming to completely separate the superimposed interference patterns, parallel acquisition is impractical this arrangement.

Similar to the example of Figure 6, the use of a sequential acquisition scheme in the example of Figure 7 allows the full NA of the objective lens to be available for both illumination and detection. However, the system suffers the same problem of low measurement speed due to sequential acquisition. Therefore, it is desirable to have a df-DHM capable of performing parallel acquisition such that a high measurement speed and a high design flexibility can be simultaneously obtained.

Figure 8 schematically illustrates the imaging branch of a dark field digital holographic microscope (df-DHM) 1000 in accordance with an embodiment. A dark field digital holographic microscope (df-DHM) comprises an imaging branch and an illumination branch. In this embodiment, a metrology target 1060 comprising a structure on a substrate 1050 is illuminated by two illumination beams of radiation, i.e., a first illumination beam of radiation 1010 and a second illumination beam of radiation 1020. In an embodiment, such two illumination beams 1010, 1020 may simultaneously illuminate the metrology target 1060.

In an embodiment, the first illumination beam 1010 may be incident on the metrology target 1060 at a first angle of incidence in a first direction with respect to the optical axis OA. The second illumination beam 1020 may be incident on the metrology target 1060 at a second angle of incidence in a second direction with respect to the optical axis OA. The first angle of incidence of the first illumination beam 1010 and the second angle of incidence of the second illumination beam 1020 may be substantially the same. The angle of incidence of each illumination beam may be, for example in the range of 70 degrees to 90 degrees, in the range of 50 degrees to 90 degrees, in the range of 30 degrees to 90 degrees, in the range of 10 degrees to 90 degrees. The illumination of the metrology target 1060 may result in radiation being scattered from the target. In an embodiment, the first illumination beam 1010 may be incident on the metrology target 1060 at a first azimuthal angle, corresponding to the first direction. The second illumination beam 1020 may be incident on the metrology target 1060 at a second azimuthal angle, corresponding to the second direction. The first azimuthal angle of the first illumination beam 1010 and the second azimuthal angle of the second illumination beam 1020 may be different; e.g., opposing angles 180 degrees apart.

Depending on the structure of the metrology target 1060, the scattered radiation may comprise reflected radiation, diffracted radiation or transmitted radiation. In this embodiment, the metrology target may be a diffraction-based overlay target; and each illumination beam may correspond to a scattered beam comprising at least one non-zeroth diffraction order. Each scattered beam carries information of the illuminated metrology target. For example, the first illumination beam 1010 may correspond to the first scattered beam 1011 comprising the positive first diffraction order +1$^{st}$DF; the second illumination beam 1020 may correspond to the second scattered beam 1021 comprising the negative first diffraction order -1$^{st}$ DF. The zeroth diffraction order and other undesired diffraction orders may either be blocked by a beam blocking element (not shown) or configured to completely fall outside the NA of the objective lens 1070. As a result, the df-DHM may be operated in a dark field mode. Note that, in some embodiments, one or more optical elements, e.g., a lens combination, may be used to achieve same optical effect of the objective lens 1070.

Both scattered beams 1011, 1021 may be collected by objective lens 1070 and subsequently re-focused onto an image sensor 1080. Objective lens 1070 may comprise multiple lenses, and/or df-DHM 1000 may comprise a lens system having two or more lenses, e.g., an objective lens and an imaging lens similar to the exemplary df-DHG of Figure 7, thereby defining a pupil plane of the objective lens between the two lenses and an image plane at the focus of the imaging lens. In this embodiment, a portion 1012 of the first scattered beam 1011 and a portion 1022 of the second scattered beam 1021 are simultaneously incident at a common position of the image sensor 1080. At the same time, two reference beams of radiation, i.e. a first reference beam 1030 and a second reference beam 1040, are incident on the same position of the image sensor 1080. Such four beams may be grouped into two pairs of scattered radiation and reference radiation. For example, the first scattered-reference beam pair may comprise the portion 1012 of the first scattered beam 1011 and the first reference beam 1030. Likewise, the portion 1022 of the second scattered-reference beam pair may comprise the second scattered beam 1021 and the second reference beam 1040. These two scattered-reference beam pairs may subsequently form two interference patterns (holographic images) which at least partially overlap in spatial domain.

In an embodiment, in order to separate the two at least partially, spatially overlapping interference patterns (e.g., in the spatial frequency domain), the first reference beam 1030 may have a first angle of incidence with respect to the optical axis OA and the second reference beam 1040 may have a second angle of incidence with respect to the optical axis OA; the first angle of incidence and the second angle of incidence being different. Alternatively or in addition, the first reference beam 1030 may have a first azimuthal angle with respect to the optical axis OA and the second reference beam 1040 may have a second azimuthal angle with respect to the optical axis OA; the first and second azimuthal angles being different.

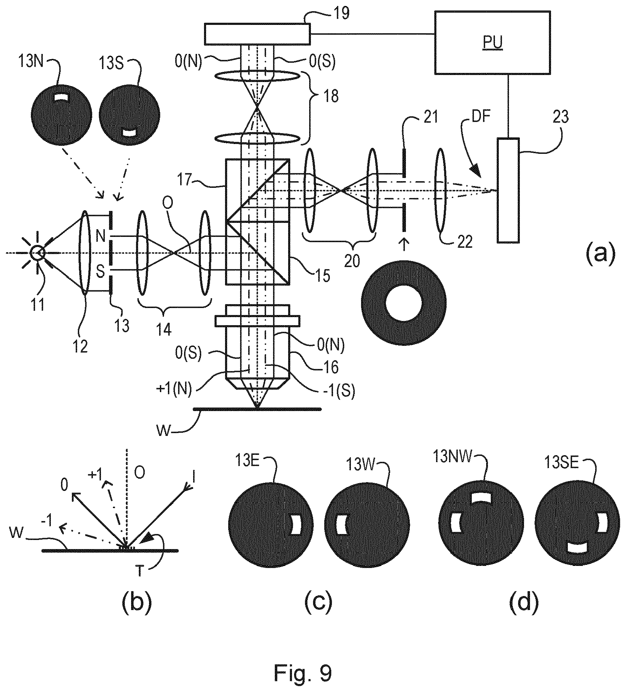

Figure 9(a) presents an embodiment of a metrology apparatus and, more specifically, a dark field scatterometer. A target T and diffracted rays of measurement radiation used to illuminate the target are illustrated in more detail in Figure 9(b). The metrology apparatus illustrated is of a type known as a dark field metrology apparatus. The metrology apparatus may be a stand-alone device or incorporated in either the lithographic apparatus LA, e.g., at the measurement station, or the lithographic cell LC. An optical axis, which has several branches throughout the apparatus, is represented by a dotted line O. In this apparatus, light emitted by source 11 (e.g., a xenon lamp) is directed onto substrate W via a beam splitter 15 by an optical system comprising lenses 12, 14 and objective lens 16. These lenses are arranged in a double sequence of a 4F arrangement. A different lens arrangement can be used, provided that it still provides a substrate image onto a detector, and simultaneously allows for access of an intermediate pupil-plane for spatial-frequency filtering. Therefore, the angular range at which the radiation is incident on the substrate can be selected by defining a spatial intensity distribution in a plane that presents the spatial spectrum of the substrate plane, here referred to as a (conjugate) pupil plane. In particular, this can be done by inserting an aperture plate 13 of suitable form between lenses 12 and 14, in a plane which is a back-projected image of the objective lens pupil plane. In the example illustrated, aperture plate 13 has different forms, labeled 13N and 13S, allowing different illumination modes to be selected. The illumination system in the present examples forms an off-axis illumination mode. In the first illumination mode, aperture plate 13N provides off-axis from a direction designated, for the sake of description only, as 'north'. In a second illumination mode, aperture plate 13S is used to provide similar illumination, but from an opposite direction, labeled 'south'. Other modes of illumination are possible by using different apertures. The rest of the pupil plane is desirably dark as any unnecessary light outside the desired illumination mode will interfere with the desired measurement signals.

As shown in Figure 9(b), target T is placed with substrate W normal to the optical axis O of objective lens 16. The substrate W may be supported by a support (not shown). A ray of measurement radiation I impinging on target T from an angle off the axis O gives rise to a zeroth order ray (solid line 0) and two first order rays (dot-chain line +1 and double dot-chain line -1). It should be remembered that with an overfilled small target, these rays are just one of many parallel rays covering the area of the substrate including metrology target T and other features. Since the aperture in plate 13 has a finite width (necessary to admit a useful quantity of light, the incident rays I will in fact occupy a range of angles, and the diffracted rays 0 and +1/-1 will be spread out somewhat. According to the point spread function of a small target, each order +1 and -1 will be further spread over a range of angles, not a single ideal ray as shown. Note that the grating pitches of the targets and the illumination angles can be designed or adjusted so that the first order rays entering the objective lens are closely aligned with the central optical axis. The rays illustrated in Figure 9(a) and 9(b) are shown somewhat off axis, purely to enable them to be more easily distinguished in the diagram.

At least the 0 and +1 orders diffracted by the target T on substrate W are collected by objective lens 16 and directed back through beam splitter 15. Returning to Figure 9(a), both the first and second illumination modes are illustrated, by designating diametrically opposite apertures labeled as north (N) and south (S). When the incident ray I of measurement radiation is from the north side of the optical axis, that is when the first illumination mode is applied using aperture plate 13N, the +1 diffracted rays, which are labeled +1(N), enter the objective lens 16. In contrast, when the second illumination mode is applied using aperture plate 13S the -1 diffracted rays (labeled 1(S)) are the ones which enter the lens 16.

A second beam splitter 17 divides the diffracted beams into two measurement branches. In a first measurement branch, optical system 18 forms a diffraction spectrum (pupil plane image) of the target on first sensor 19 (e.g. a CCD or CMOS sensor) using the zeroth and first order diffractive beams. Each diffraction order hits a different point on the sensor, so that image processing can compare and contrast orders. The pupil plane image captured by sensor 19 can be used for focusing the metrology apparatus and/or normalizing intensity measurements of the first order beam. The pupil plane image can also be used for many measurement purposes such as reconstruction.

In the second measurement branch, optical system 20, 22 forms an image of the target T on sensor 23 (e.g. a CCD or CMOS sensor). In the second measurement branch, an aperture stop 21 is provided in a plane that is conjugate to the pupil-plane. Aperture stop 21 functions to block the zeroth order diffracted beam so that the image of the target formed on sensor 23 is formed only from the -1 or +1 first order beam. The images captured by sensors 19 and 23 are output to processor PU which processes the image, the function of which will depend on the particular type of measurements being performed. Note that the term 'image' is used here in a broad sense. An image of the grating lines as such will not be formed, if only one of the -1 and +1 orders is present.

The particular forms of aperture plate 13 and field stop 21 shown in Figure 9 are purely examples. In another embodiment of the invention, on-axis illumination of the targets is used and an aperture stop with an off-axis aperture is used to pass substantially only one first order of diffracted light to the sensor. In yet other embodiments, 2nd, 3rd and higher order beams (not shown in Figure 9) can be used in measurements, instead of or in addition to the first order beams.

In order to make the measurement radiation adaptable to these different types of measurement, the aperture plate 13 may comprise a number of aperture patterns formed around a disc, which rotates to bring a desired pattern into place. Note that aperture plate 13N or 13S can only be used to measure gratings oriented in one direction (X or Y depending on the set-up). For measurement of an orthogonal grating, rotation of the target through 90° and 270° might be implemented. Simultaneous measurement in opposing directions can be implemented using a suitable aperture plate (e.g., having apertures as a pair of diagonally opposed quadrants) and wedges (to separate the images) in the imaging branch.

Some metrology devices, such as the DHM described above, use spatially-coherent oblique illumination with an angle-of-incidence of about 70 degrees relative to the wafer normal. Ideally, the illumination spot on the wafer would be perfectly homogenous, e.g., having a relative intensity variation within the spot of less than about 0.5 %. However, homogeneous illumination is difficult to realize with spatially coherent illumination. In practice, some level of speckle (or micro-speckle) in the illumination beam will be unavoidable.

In addition to this micro-speckle, the target or structure being measured may be subject to some height variations $\Delta Z$ due to, for example, vertical position errors. In this context, vertical position or the Z-direction refers to the direction normal to the substrate plane.

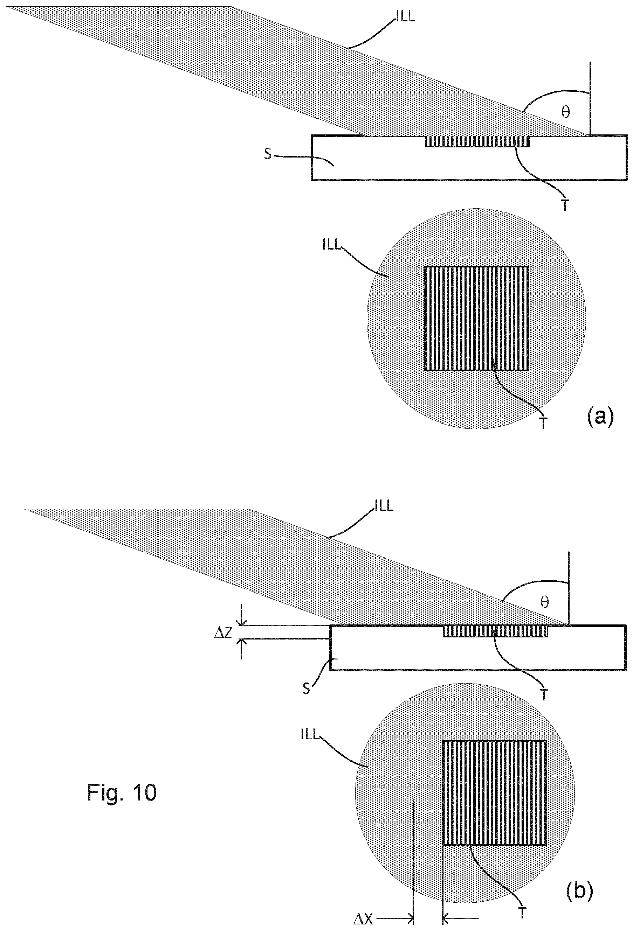

Figure 10 illustrates the effect of height variation of the substrate. Figure 10(a) shows an oblique beam of illumination ILL incident on a target T on substrate S at angle $\theta$ with respect to the substrate normal. The substrate is at a first height or vertical position; this first height may be the target or nominal height, defined as being the height at which there is zero optical path length difference (OPD) between diffracted radiation from the target and corresponding reference radiation. More specifically, this nominal vertical position may be defined as the position OPD=0 between the object beam and the reference beam in the center of the Field of View (FoV). This nominal vertical position may be determined during sensor set-up and, if required, may be regularly re-calibrated. In normal imaging applications the nominal vertical position Z=0 may also correspond to best focus or the height which generates the sharpest image, however that is not a requirement. Figure 10(a) shows this arrangement in a side-on view and top-down view.

Figure 10(b) shows the same arrangement as that of Figure 10(a), but where there has been a change in vertical position $\Delta Z$ of the target. As a result of this vertical position variation, the illumination spot shifts over the target by a displacement $\Delta X = \Delta Z \tan(\theta)$. As a result of this displacement $\Delta X$, the target will be measured by a different portion of the illumination spot. As this illumination spot will typically have some inhomogeneity, there will be a resultant error in the Region of Interest (RoI) captured on the detector, where the RoI is the region of the captured target image used to determine the parameter of interest.

As such, a method is disclosed for determining the vertical position offset $\Delta Z$ with respect to a nominal vertical position (e.g., the vertical position where OPD=0 at a detection plane between the scattered radiation, scattered by the target, and reference radiation), via a measurement using a plurality of wavelengths.

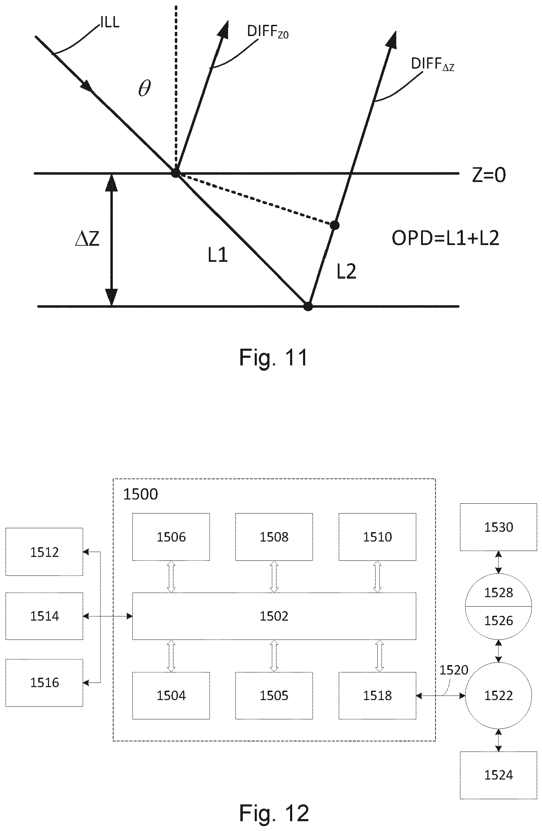

Figure 11 illustrates the relationship between OPD and vertical position offset $\Delta Z$. The Figure shows plane wave illumination ILL incident at angle $\theta$, and resultant diffraction $DIFF_{Z0}$ from a target at level Z=0 and diffraction $DIFF_{\Delta Z}$ from a target at level $\Delta Z$. OPD is the additional distance travelled represented by L1+L2.

In holographic microscopy (e.g., DHM), the radiation diffracted by the target is the object beam that is imaged on the detector. The reference beam is coherently added to this object beam and the optical path difference (OPD) between the interfering beams is adjusted in such a way that OPD=0 at the nominal or target vertical position for the substrate.

The phase difference $\varphi$ between the object beam and the reference beam at the detector plane is:

$$\varphi = 2\pi \frac{OPD}{\lambda} + \psi_s(\lambda) = 4\pi \frac{\Delta Z}{\lambda} F(\theta, \lambda, P) + \psi_s(\lambda)$$

where $\Delta Z$ is the vertical position offset with respect to nominal, phase term $\psi_s(\lambda)$ represents a wavelength-dependent phase jump of the radiation diffracted by the grating. It can be shown that this term is responsible to a small process-dependent focus offset. The physics behind this is completely analogous to the process-dependency in a Level Sensor used for measuring a wafer height map in a lithography tool. More detail of this process-dependency is further described in a scientific paper: Jan van der Werf, J. Vac. Sci. Technol. B, Vol 10, No. 2, Mar/Apr 1992, which is incorporated herein by reference. F($\theta$,$\lambda$,$P$) is a known function of wavelength $\lambda$, illumination angle $\theta$ and target grating pitch $P$:

$$F(\theta, \lambda, P) = \frac{1}{\cos\theta} + \frac{1}{\sqrt{1 - (\frac{\lambda}{P} - \sin\theta)^2}}$$

The measured value of the phase $\varphi$ cannot be used directly to determine defocus since the absolute value of the phase $\varphi$ is unknown. However, by measuring at multiple wavelengths, it is possible to measure a phase parameter $\Delta\varphi$ describing the change in the phase difference between the object and reference beams which results from a change in wavelength over a range $\Delta\lambda$. For a small wavelength step, this phase parameter or phase difference change $\Delta\varphi$ may be written as:

$$\Delta\varphi = 4\pi\Delta Z(\frac{1}{\lambda}\frac{\partial F}{\partial\lambda} - \frac{1}{\lambda^2}F)\Delta\lambda + \frac{\partial\psi_s}{\partial\lambda}\Delta\lambda$$

From this equation the vertical position offset $\Delta Z$ with respect to nominal can be determined from the measured phase difference change $\Delta\varphi$ over a wavelength step $\Delta\lambda$:

$$\Delta Z = \frac{\lambda^2}{\left(\lambda\frac{\partial F}{\partial\lambda} - F\right)\lambda}\left[\frac{1}{4\pi}\frac{\Delta\varphi}{\Delta\lambda} - \frac{\partial\psi_s}{\partial\lambda}\right]$$

where $\lambda$ is an average or central wavelength in the wavelength step $\Delta\lambda$.

The equation shown for $\Delta\varphi$ is equivalent to $\frac{d}{d\lambda}\varphi \times \Delta\lambda$. In this sense it is an approximation, but it will hold for a small wavelength step as this is the definition of the derivative operator.

The term $\frac{\partial\psi_s}{\partial\lambda}$ represents a process-dependent unknown vertical position offset that is usually of the order of about 100 nm (e.g., small enough to be ignored or assumed to be this value). This is a typical number observed in present lithography processes. As OPD increases, phase will vary more with $\lambda$. This process-dependency essentially represents a lower limit on which the height offset can be reliably determined. This is the same as process dependency in a level sensor. As such, the method may simply ignore this term; e.g., determine vertical position offset $\Delta Z$ from:

$$\Delta Z = \frac{\lambda^2}{\left(\lambda\frac{\partial F}{\partial\lambda} - F\right)\lambda}\left[\frac{1}{4\pi}\frac{\Delta\varphi}{\Delta\lambda}\right]$$

or else it may be accounted for by assuming it to be 100nm. Alternatively, depending on the knowledge of the stack,

term $\frac{\partial \psi_s}{\partial \lambda}$ could be obtained from a detailed simulation of the stack, to obtain a higher accuracy.

Based on this observation, a method has been devised for determining the vertical position offset from a multiple wavelength measurement. The method relies on detecting phase changes at a single point in the field as the wavelength is changed; i.e., effectively measuring the derivative $d\varphi/d\lambda$. This term is independent of grating position since the phase due to a grating shift $X$ is given by $2\pi X/P$, which is independent of wavelength. This does assume that this position is sufficiently stable, however this is a requirement for a DHM in any case. Furthermore, to make the measurement more robust for such positional errors, each of a pair of complementary diffraction orders (e.g., both -1st and +1st orders) can be processed, as any phase variation in these orders due to a position change will have an opposite sign and therefore is distinguishable (and can be removed) from a determination of phase variation due to wavelength variation.

The method may comprise obtaining at least one interference pattern on the detector using a metrology device, e.g., a holographic metrology device such as illustrated in Figure 8, for each of a plurality of wavelengths. Optionally, a first and second interference pattern may be recorded simultaneously for each wavelength, each pattern, per wavelength, corresponding to a measurement of a target or structure from a respective opposing direction.

The interference pattern(s) may be processed to calculate a complex field of radiation at the detector ("complex" in this context meaning that both amplitude and phase information is present) associated with the scattered radiation (object beam). Such calculation of a complex field of radiation from an interference pattern formed by interfering reference radiation with radiation scattered from an object is known in general terms from holography. Further details about how to perform such calculations in the context of metrology for lithography may be found for example in US2016/0061750A1, which is hereby incorporated by reference.

As stated above, the equation provided for vertical position offset $\Delta Z$ above is an approximation which holds for a small wavelength step. As a result, should a larger wavelength step be used, the accuracy of the height inference will suffer. The point at which this approximation breaks down depends on $\frac{\partial^2}{\partial(\lambda)^2}$ and thus implicitly on the stack and the angle of incidence.

In another embodiment, which does not rely on the above mentioned approximation and therefore can be used regardless of the wavelength spacing, it is proposed to evaluate the phase $\varphi$ at two or more wavelengths independently. This will yield a less wieldy analytical expression. $\Delta\varphi$ would be the difference between the two phase values $\varphi$ in this case.

The method in this embodiment may comprise fitting a sine function through the hologram image or complex field acquired by the detector. A maximum in this fit corresponds to constructive interference, which in turn corresponds to $\varphi = n \times 2\pi$, $n \in \mathbb{N}$. If the pathlengths are properly matched, i.e., the sample is in the desired position $\Delta Z = 0$, this maximum will be in the same place regardless of wavelength. As such, the method may comprise measuring the shift of this maximum to determine the vertical position offset $\Delta Z$.

The concepts disclosed herein are not limited to holography metrology, and can be implemented using other metrology techniques (e.g., using a scatterometry based metrology device such as illustrated in Figure 9(a)). All that is required is that the complex field of the measurement radiation be accessible. Other methods for accessing the complex field include phase-retrieval or shear interferometry. Phase-retrieval techniques in a lithography context are described for example, in US patent publication US2019/0107781, which is incorporated herein by reference. These methods do not need a separate reference beam.

With a complex field determined for at least two wavelengths, the change in the phase difference between the object and reference beams $\Delta\varphi$ which results from a change in wavelength over a range $\Delta\lambda$ can be determined. This change in the phase difference and wavelength step $\frac{\Delta\varphi}{\Delta\lambda}$ can then be put into the Equation for $\Delta Z$ given above, to determine the vertical position $\Delta Z$ with respect to nominal.

The vertical position $\Delta Z$ can then be used, for example, to reposition the wafer (or sensor), e.g., back to the nominal position Z=0 and/or laterally such that the target remains within a constant position within the measurement spot. It could optionally also be used as a feedforward correction, for example if there is a trend such as a tilt of the sample.

The concepts disclosed herein may be implemented into a type of level sensor or focus sensor for a holographic tool such as that illustrated in Figure 8. Such a level sensor would require no additional hardware, and the level sensing may be determined directly from the measurements performed

It can be appreciated that in many present metrology techniques using many present metrology tools, some or all targets are measured at a plurality of wavelengths. Therefore, the proposed method can be implemented without any hardware modification of the metrology tool, and without any additional metrology effort.

Figure 12 is a block diagram that illustrates a computer system 1500 that may assist in implementing the methods and flows disclosed herein. Computer system 1500 includes a bus 1502 or other communication mechanism for communicating information, and a processor 1504 (or multiple processors 1504 and 1505) coupled with bus 1502 for processing information. Computer system 1500 also includes a main memory 1506, such as a random access memory (RAM) or other dynamic storage device, coupled to bus 1502 for storing information and instructions to be executed by processor 1504. Main memory 1506 also may be used for storing temporary variables or other intermediate information during execution of instructions to be executed by processor 1504. Computer system 1500 further includes a read only memory (ROM) 1508 or other static storage device coupled to bus 1502 for storing static information and instructions for processor 1504. A storage device 1510, such as a magnetic disk or optical disk, is provided and coupled to bus 1502 for storing information and instructions.

Computer system 1500 may be coupled via bus 1502 to a display 1512, such as a cathode ray tube (CRT) or flat panel or touch panel display for displaying information to a computer user. An input device 1514, including alphanumeric and other keys, is coupled to bus 1502 for communicating information and command selections to processor 1504. Another type of user input device is cursor control 1516, such as a mouse, a trackball, or cursor direction keys for communicating direction information and command selections to processor 1504 and for controlling cursor movement on display 1512. This input device typically has two degrees of freedom in two axes, a first axis (e.g., x) and a second axis (e.g., y), that allows the device to specify positions in a plane. A touch panel (screen) display may also be used as an input device.

One or more of the methods as described herein may be performed by computer system 1500 in response to processor 1504 executing one or more sequences of one or more instructions contained in main memory 1506. Such instructions may be read into main memory 1506 from another computer-readable medium, such as storage device 1510. Execution of the sequences of instructions contained in main memory 1506 causes processor 1504 to perform the process steps described herein. One or more processors in a multi-processing arrangement may also be employed to execute the sequences of instructions contained in main memory 1506. In an alternative embodiment, hard-wired circuitry may be used in place of or in combination with software instructions. Thus, the description herein is not limited to any specific combination of hardware circuitry and software.

The term "computer-readable medium" as used herein refers to any medium that participates in providing instructions to processor 1504 for execution. Such a medium may take many forms, including but not limited to, non-volatile media, volatile media, and transmission media. Non-volatile media include, for example, optical or magnetic disks, such as storage device 1510. Volatile media include dynamic memory, such as main memory 1506. Transmission media include coaxial cables, copper wire and fiber optics, including the wires that comprise bus 1502. Transmission media can also take the form of acoustic or light waves, such as those generated during radio frequency (RF) and infrared (IR) data communications. Common forms of computer-readable media include, for example, a floppy disk, a flexible disk, hard disk, magnetic tape, any other magnetic medium, a CD-ROM, DVD, any other optical medium, punch cards, paper tape, any other physical medium with patterns of holes, a RAM, a PROM, and EPROM, a FLASH-EPROM, any other memory chip or cartridge, a carrier wave as described hereinafter, or any other medium from which a computer can read.

Various forms of computer readable media may be involved in carrying one or more sequences of one or more instructions to processor 1504 for execution. For example, the instructions may initially be borne on a magnetic disk of a remote computer. The remote computer can load the instructions into its dynamic memory and send the instructions over a telephone line using a modem. A modem local to computer system 1500 can receive the data on the telephone line and use an infrared transmitter to convert the data to an infrared signal. An infrared detector coupled to bus 1502 can receive the data carried in the infrared signal and place the data on bus 1502. Bus 1502 carries the data to main memory 1506, from which processor 1504 retrieves and executes the instructions. The instructions received by main memory 1506 may optionally be stored on storage device 1510 either before or after execution by processor 1504.

Computer system 1500 also preferably includes a communication interface 1518 coupled to bus 1502. Communication interface 1518 provides a two-way data communication coupling to a network link 1520 that is connected to a local network 1522. For example, communication interface 1518 may be an integrated services digital network (ISDN) card or a modem to provide a data communication connection to a corresponding type of telephone line. As another example, communication interface 1518 may be a local area network (LAN) card to provide a data communication connection to a compatible LAN. Wireless links may also be implemented. In any such implementation, communication interface 1518 sends and receives electrical, electromagnetic or optical signals that carry digital data streams representing various types of information.

Network link 1520 typically provides data communication through one or more networks to other data devices. For example, network link 1520 may provide a connection through local network 1522 to a host computer 1524 or to data equipment operated by an Internet Service Provider (ISP) 1526. ISP 1526 in turn provides data communication services through the worldwide packet data communication network, now commonly referred to as the "Internet" 1528. Local network 1522 and Internet 1528 both use electrical, electromagnetic or optical signals that carry digital data streams. The signals through the various networks and the signals on network link 1520 and through communication interface 1518, which carry the digital data to and from computer system 1500, are exemplary forms of carrier waves transporting the information.

Computer system 1500 may send messages and receive data, including program code, through the network(s), network link 1520, and communication interface 1518. In the Internet example, a server 1530 might transmit a requested code for an application program through Internet 1528, ISP 1526, local network 1522 and communication interface 1518. One such downloaded application may provide for one or more of the techniques described herein, for example. The received code may be executed by processor 1504 as it is received, and/or stored in storage device 1510, or other non-volatile storage for later execution. In this manner, computer system 1500 may obtain application code in the form of a carrier wave.

Further embodiments are disclosed in the subsequent list of numbered clauses:

1. A method for determining a vertical position of a structure on a substrate with respect to a nominal vertical position; comprising:

    obtaining complex field data relating to scattered radiation from said structure, for a plurality of different wavelengths;
    determining variation in a phase parameter with wavelength from said complex field data; and
    determining said vertical position with respect to a nominal vertical position from the determined variation in phase with wavelength.

2. A method as defined in clause 1, wherein said complex field data relates to interference of object radiation scattered by said structure and reference radiation at a detection plane, for each of said plurality of wavelengths.
3. A method as defined in clause 2, wherein said phase parameter comprises a phase difference between said object radiation and reference radiation at the detection plane.
4. A method as defined in clause 2 or 3, wherein said nominal vertical position comprises a vertical position for which an optical path length difference at a detection plane between said object radiation and said reference radiation is zero.
5. A method as defined in any preceding clause, wherein said step of determining said vertical position comprises determining said vertical position from said variation in phase parameter with wavelength, the angle of incidence of measurement radiation on said target to obtain said object radiation, the structure pitch and an average or central wavelength of the plurality of wavelengths used to measure the structure.
6. A method as defined in any of clauses 1 to 4, wherein said step of determining said vertical position comprises fitting a sine function through the complex field at each wavelength of said plurality of wavelengths; determining the positions of the maximum in each said fitting; and determining said vertical position from the differences in the positions of said maximum.
7. A method as defined in any preceding clause, wherein said complex field data further relates to each of a pair of complementary diffraction orders and the method comprises distinguishing variation in said phase parameter due to a variation in lateral position of the structure from said variation in the phase parameter with wavelength; and correcting for said variation in said phase parameter due to a variation in lateral position of the structure.
8. A method as defined in any preceding clause, comprising using said determined vertical position to reposition the structure with respect to a sensor used to measure the structure such that the target remains within a constant position with respect to measurement radiation used to measure the target.
9. A method as defined in any preceding clause, comprising performing a measurement of said structure using a plurality of wavelengths to obtain said complex field data.
10. A method as defined in clause 9, wherein said measurement is a holographic measurement.
11. A method as defined in clause 9 comprising performing a phase-retrieval method or shear interferometry to obtain said complex field data.
12. A computer program comprising instructions for a processor which cause the processor and/or associated apparatus to perform the method of any preceding clause.
13. A processing device and associated program storage, said program storage comprising instructions for the processor which cause the processor to perform the method of any of clauses 1 to 11.
14. A metrology apparatus for determining a characteristic of interest of a target, said metrology apparatus comprising a processing device and associated program storage, said program storage comprising instructions for the processor which cause the processor to perform the method of any of clauses 1 to 11.
15. A metrology apparatus as defined in clause 14, wherein said processing device and associated program storage is operable as a level sensor or focus sensor.
16. A metrology apparatus as defined in clause 14 or 15, comprising a digital holographic microscope.
17. A lithographic apparatus comprising a processing device and associated program storage, said program storage comprising instructions for the processor which cause the processor to perform the method of any of clauses 1 to 9.
18. A lithographic apparatus comprising a metrology apparatus as defined in any of clauses 14 to 16.

19. A lithocell comprising a lithographic apparatus and a metrology apparatus as defined in any of clauses 14 to 16.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Although specific reference may have been made above to the use of embodiments of the invention in the context of optical lithography, it will be appreciated that the invention, where the context allows, is not limited to optical lithography and may be used in other applications, for example imprint lithography.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

## Claims

**1.** A method for determining a vertical position of a structure on a substrate with respect to a nominal vertical position; comprising:

obtaining complex field data relating to scattered radiation from said structure, for a plurality of different wavelengths;
determining variation in a phase parameter with wavelength from said complex field data; and
determining said vertical position with respect to a nominal vertical position from the determined variation in phase with wavelength.

**2.** A method as claimed in claim 1, wherein said complex field data relates to interference of object radiation scattered by said structure and reference radiation at a detection plane, for each of said plurality of wavelengths.

**3.** A method as claimed in claim 2, wherein said phase parameter comprises a phase difference between said object radiation and reference radiation at the detection plane.

**4.** A method as claimed in claim 2 or 3, wherein said nominal vertical position comprises a vertical position for which an optical path length difference at a detection plane between said object radiation and said reference radiation is zero.

**5.** A method as claimed in any preceding claim, wherein said step of determining said vertical position comprises determining said vertical position from said variation in phase parameter with wavelength, the angle of incidence of measurement radiation on said target to obtain said object radiation, the structure pitch and an average or central wavelength of the plurality of wavelengths used to measure the structure.

**6.** A method as claimed in any of claims 1 to 4, wherein said step of determining said vertical position comprises fitting a sine function through the complex field at each wavelength of said plurality of wavelengths; determining the positions of the maximum in each said fitting; and determining said vertical position from the differences in the positions of said maximum.

**7.** A method as claimed in any preceding claim, wherein said complex field data further relates to each of a pair of complementary diffraction orders and the method comprises distinguishing variation in said phase parameter due to a variation in lateral position of the structure from said variation in the phase parameter with wavelength; and correcting for said variation in said phase parameter due to a variation in lateral position of the structure.

**8.** A method as claimed in any preceding claim, comprising using said determined vertical position to reposition the structure with respect to a sensor used to measure the structure such that the target remains within a constant position with respect to measurement radiation used to measure the target.

**9.** A method as claimed in any preceding claim, comprising performing a measurement of said structure using a plurality of wavelengths to obtain said complex field data.

**10.** A method as claimed in claim 9, wherein said measurement is a holographic measurement.

**11.** A method as claimed in claim 9 comprising performing a phase-retrieval method or shear interferometry to obtain said complex field data.

**12.** A computer program comprising instructions for a processor which cause the processor and/or associated apparatus to perform the method of any preceding claim.

**13.** A processing device and associated program storage, said program storage comprising instructions for the processor which cause the processor to perform the method of any of claims 1 to 11.

**14.** A metrology apparatus for determining a characteristic of interest of a target, said metrology apparatus comprising a processing device and associated program storage, said program storage comprising instructions for the processor which cause the processor to perform the method of any of claims 1 to 11.

**15.** A lithographic apparatus comprising a metrology apparatus as claimed in claim 14.

SO
BD
IL
LA
MA
M2
M1
C
B
T
PM
W
P1
P2
C C C C
C C C C
C C C
C
PS
Z
X
Y
X
WT
IF
PW
SCS
LC
SC x 4
LACU
I/O1
BK
CH
BK
CH
TCU
LB
LA
RO
I/O2
CH
BK
CH
BK
DE x 4

Fig. 1

Fig. 2

LA
SC1
SC3
0
-1
+1
CL
MT
SC2
2
4
SM1
PU
z
x
W
6
I
λ
Z
8
X

Fig. 3

Fig. 4

IS
IM2
IM1
IL
WG2
WG1
OB
IB2
-1st DF
+1st DF
IB1
OT
WA

Fig. 5

t = T1
IS
IM1
IL
OB
+1st DF
IB1
OT
WA
t = T2
IS
IM2
IL
OB
IB2
-1st DF
OT
WA

Fig. 6

z
y
x
70
6
51, 52
16, 18
41, 42
F2
2
20
$\Theta_{ill}$
31, 32
F1
21, 22
8
W

Fig. 7

1000
z
y
x
1090
1080
1040
1030
1022
1012
OA
1070
1021
1011
1020
1010
1050
1060

Fig. 8

19
PU
13N
13S
0(N)
0(S)
18
21
DF
23
17
O
N
S
11
12
13
14
15
20
22
(a)
0(S)
0(N)
16
+1(N)
-1(S)
W
13E
13W
13NW
13SE
0
+1
O
I
-1
W
T
(b)
(c)
(d)

Fig. 9

ILL
θ
S
T
ILL
T
(a)
ILL
θ
ΔZ
S
T
ILL
(b)
T
ΔX

Fig. 10

ILL
DIFF_Z0
DIFF_ΔZ
θ
Z=0
ΔZ
L1
L2
OPD=L1+L2

Fig. 11

1500
1506
1508
1510
1512
1514
1502
1516
1504
1505
1518
1520
1530
1528
1526
1522
1524

Fig. 12

# EUROPEAN SEARCH REPORT

Application Number
EP 22 16 3109

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2020/174425 A1 (GEORGES III JAMES A [US]) 4 June 2020 (2020-06-04)<br>* paragraph [0004] *<br>* paragraphs [0027] - [0032] *<br>* paragraphs [0044] - [0057]; figures 4-6 *<br>* paragraphs [0062] - [0072]; figures 10-12 *<br>----- | 1-3,9-14 | INV.<br>G03F7/20<br>G01N21/21<br>G03H1/04 |
| Y | US 2011/032500 A1 (STRAAIJER ALEXANDER [NL]) 10 February 2011 (2011-02-10)<br>* paragraphs [0006] - [0008] *<br>* paragraphs [0040] - [0057]; figures 2-4 *<br>* paragraph [0092]; figures 8,12 * | 1-3,9-15 | |
| Y | -& US 5 880 838 A (MARX DAVID [US] ET AL) 9 March 1999 (1999-03-09)<br>* column 3, lines 9-38 *<br>* column 9, line 10 - column 11, line 40; figures 2,3A,3B *<br>----- | 1-3,9-15 | |
| | | | TECHNICAL FIELDS SEARCHED (IPC) |
| Y<br>A | US 2009/109438 A1 (FUKUE KUMIKO [JP]) 30 April 2009 (2009-04-30)<br>* paragraphs [0002] - [0014] *<br>* paragraphs [0022] - [0025]; figures 1-3 *<br>* paragraphs [0033] - [0045]; figures 4,6 *<br>* paragraphs [0046] - [0053]; figures 5A-5E *<br>----- | 1-3,9-15<br>4-8 | G03F<br>G03H<br>G01N |

The present search report has been drawn up for all claims

| Place of search | Date of completion of the search | Examiner |
|---|---|---|
| Munich | 31 August 2022 | van Toledo, Wiebo |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

2

EPO FORM 1503 03.82 (P04C01)

# ANNEX TO THE EUROPEAN SEARCH REPORT ON EUROPEAN PATENT APPLICATION NO. EP 22 16 3109

This annex lists the patent family members relating to the patent documents cited in the above-mentioned European search report. The members are as contained in the European Patent Office EDP file on
The European Patent Office is in no way liable for these particulars which are merely given for the purpose of information.

31-08-2022

| Patent document cited in search report | | Publication date | Patent family member(s) | | | Publication date |
|---|---|---|---|---|---|---|
| US 2020174425 | A1 | 04-06-2020 | US | 10466649 | B1 | 05-11-2019 |
| | | | US | 2020174425 | A1 | 04-06-2020 |
| US 2011032500 | A1 | 10-02-2011 | US | 2011032500 | A1 | 10-02-2011 |
| | | | WO | 2009115342 | A1 | 24-09-2009 |
| US 5880838 | A | 09-03-1999 | NONE | | | |
| US 2009109438 | A1 | 30-04-2009 | JP | 2009103598 | A | 14-05-2009 |
| | | | US | 2009109438 | A1 | 30-04-2009 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- US 20160161864 A1
- US 20100328655 A1
- US 20060066855 A1
- WO 2021121733 A1
- US 6952253 B
- US 20100328655 A
- US 2011102753 A1
- US 20120044470 A
- US 20110249244 A
- US 20110026032 A
- EP 1628164 A
- US 451599
- US 11708678 B
- US 12256780 B
- US 12486449 B
- US 12920968 B
- US 12922587 B
- US 13000229 B
- US 13033135 B
- US 13533110 B
- US 13891410 B
- US 20160161863 A
- US 20160370717 A1
- US 2006033921 A1
- US 2010201963 A1
- US 2006066855 A1
- WO 2009078708 A
- WO 2009106279 A
- US 20110027704 A
- US 20110043791 A
- US 20120123581 A
- US 20130258310 A
- US 20130271740 A
- WO 2013178422 A1
- WO 2019197117 A1
- US 20160061750 A1
- US 20190107781 A


### Non-patent literature cited in the description


- **JAN VAN DER WERF.** *J. Vac. Sci. Technol. B,* March 1992, vol. 10 (2